(19) Europäisches Patentamt
European Patent Office
Office européen des brevets

(11) **EP 2 374 167 B1**

(12) **FASCICULE DE BREVET EUROPEEN**

(45) Date de publication et mention de la délivrance du brevet:
**11.06.2014 Bulletin 2014/24**

(21) Numéro de dépôt: **09804275.7**

(22) Date de dépôt: **18.12.2009**

(51) Int Cl.:
*H01L 39/24* [(2006.01)]     *C23C 18/12* [(2006.01)]

(86) Numéro de dépôt international:
**PCT/FR2009/001448**

(87) Numéro de publication internationale:
**WO 2010/076428 (08.07.2010 Gazette 2010/27)**

(54) **PROCÉDÉ DE DÉPÔT DE FILMS D'OXYDES SUR TUBES MÉTALLIQUES TEXTURÉS**

VERFAHREN ZUM ABSCHEIDEN VON OXIDFILMEN AUF TEXTURIERTEN METALLRÖHREN

METHOD FOR DEPOSITING OXIDE FILMS ON TEXTURED METAL PIPES

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **18.12.2008 FR 0807113**

(43) Date de publication de la demande:
**12.10.2011 Bulletin 2011/41**

(73) Titulaire: **Centre National de la Recherche Scientifique (CNRS)**
**75794 Paris Cedex 16 (FR)**

(72) Inventeurs:
• **ODIER, Philippe**
  **F-38640 Claix (FR)**
• **MORLENS, Stéphanie**
  **F-71100 Chalon-sur-Saône (FR)**
• **MILLON, Cyril**
  **F-38340 Voreppe (FR)**
• **CAROFF, Tristan**
  **F-38610 Gières (FR)**
• **JIMENEZ, Carmen**
  **F-38000 Grenoble (FR)**
• **SOUBEYROUX, Jean-Louis**
  **F-38340 Voreppe (FR)**
• **ALLAIS, Arnaud**
  **F-69400 Limas (FR)**
• **RIKEL, Mark**
  **50354 Huerth (DE)**

(74) Mandataire: **Schmidt, Martin Peter**
**IXAS Conseil**
**15, rue Emile Zola**
**69002 Lyon (FR)**

(56) Documents cités:
**WO-A-2006/015819    US-A1- 2002 173 426**

• YU Z M ET AL: "La2Zr2O7 films on Cu-Ni alloy by chemical solution deposition process" MATERIALS SCIENCE AND ENGINEERING B, ELSEVIER SEQUOIA, LAUSANNE, CH, vol. 130, no. 1-3, 15 juin 2006 (2006-06-15), pages 126-131, XP025099770 ISSN: 0921-5107 [extrait le 2006-06-15]
• TERANISHI R ET AL: "Growth mechanism of Y123 film by MOD-TFA process" 1 octobre 2002 (2002-10-01), PHYSICA C, NORTH-HOLLAND PUBLISHING, AMSTERDAM, NL, PAGE(S) 1033 - 1038 , XP004383045 ISSN: 0921-4534 page 1034, colonne 2, ligne 1-10
• KNOTH ET AL: "Detailed investigations on La2Zr2O7 buffer layers for YBCO-coated conductors prepared by chemical solution deposition" 16 décembre 2006 (2006-12-16), ACTA MATERIALIA, ELSEVIER, OXFORD, GB, PAGE(S) 517 - 529 , XP005806507 ISSN: 1359-6454

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**Domaine de l'invention**

La présente invention se rapporte au domaine des dispositifs supraconducteurs à haute température, c'est-à-dire aux dispositifs électriques incorporant des matériaux céramiques, notamment de type $YBa_2Cu_3O_{7-x}$ (appelés YBaCuO), qui montrent une supraconductivité à la température de l'azote liquide.

La présente invention concerne des procédés chimiques permettant l'épitaxie de films minces d'oxydes sur substrats métalliques ronds de faible diamètre millimétriques. Ces films servent à la fois de barrière chimique pour éviter la diffusion du métal dans la couche de supraconducteur YBaCuO, et de matrice pour l'épitaxie de couches supraconductrices.

Plus particulièrement, la présente invention concerne un procédé permettant la formation par voie chimique de couches tampons par l'épitaxie de films d'oxydes sur substrats métalliques avant le dépôt de la céramique de type YBaCuO.

**Etat de la technique**

Les matériaux céramiques de type YBaCuO (appelés aussi YBCO) permettent de fabriquer des dispositifs supraconducteurs à la température de l'azote liquide. Ces dispositifs comportent un substrat, en général métallique, sur lequel est déposée une couche de YBaCuO, par exemple par un procédé d'ép16itaxie pour déposer des YBaCuO à partir d'une phase gazeuse comme décrit dans les documents WO 95/02711 et US 5,945,162 (Centre National de la Recherche Scientifique). On souhaite constamment améliorer les densités de courant qui peuvent être transportées par ces dispositifs. Cette limite est liée à la décroissance rapide de la densité de courant critique $J_C$ lorsque l'on augmente l'épaisseur des couches YBaCuO. Cela est décrit par exemple dans l'article "Overcoming the barrier to 1000 A/cm width superconducting coatings" par S.R. Foltyn et al., paru dans Applied Physics Letters 87 (16), 162505 (2005). La présence de défauts cristallographiques, qui deviennent plus fréquents lorsque l'épaisseur des films YBaCuO augmente, est un des facteurs qui semblent contribuer à cette décroissance. Les films YBaCuO, déposés en général par un procédé épitaxique, doivent avoir une structure cristallographique aussi proche que possible de celle d'un monocristal ; cela implique en particulier l'alignement des grains selon deux directions perpendiculaires. La minimisation de leurs défauts cristallographiques (tels que les dislocations aux joints de grains) et des défauts d'orientation cristallographique entre les grains) est un enjeu essentiel. Pour favoriser la croissance cristalline des couches épitaxiques de YBaCuO, il serait souhaitable de les déposer sur un substrat monocristallin approprié. Mais ces substrats sont chers. En pratique, et en vue d'applications à grande échelle, on dépose donc les films YBaCuO sur des substrats métalliques texturés biaxialement.

Des substrats métalliques texturés biaxialement peuvent être obtenus par un procédé spécifique de laminage à fort écrouissage suivi d'un recuit de recristallisation ; ces substrats de forme généralement plate sont connus de l'homme du métier sous l'acronyme RABiTS (« Rolling-Assisted Biaxially Textured Substrates »). Ils sont décrits par exemple dans l'article "Deposition of biaxially-oriented metal and oxide buffer-layer films on textured Ni tapes : new substrate for high-current, high-temperature superconductors" par Qing He, D.K. Christen et al. (paru dans la revue Physica C 275 (1997), p. 155-161), dans l'article "Using RABiTS to Fabricate High-Temperature Superconducting Wire" par A. Goyal et al. (paru dans la revue JOM (Juillet 1999). p. 19 - 23), dans l'article « Industrial Fe-Ni alloys for HTS coated conductor tapes » par J.L. Soubeyroux et al. (paru dans la revue Journal of Physics, Conference Series 97 (2008), 012069), et dans l'article "Recent progress in the fabrication of high-JC tapes by epitaxial deposition of YBCO on RABiTS" par A. Goyal et al. (paru dans la revue Physica C 357-360 (2001), p. 903 - 913).

Cependant, en fonction de la nature chimique du substrat, il peut être nécessaire de déposer une couche tampon (« buffer layer ») entre la surface métallique du substrat et la céramique YBaCuO, afin d'éviter que le métal du substrat ne diffuse dans la céramique YBaCuO, et que le métal du substrat ne forme un oxyde dont la croissance perturbe la cristallographie de la surface. Cela est par exemple le cas des substrats d'alliages de nickel qui sont fréquemment utilisés pour déposer les YBaCuO. Cette couche tampon doit être à la fois dense et mince. Elle doit être dense afin de constituer une barrière efficace pour la diffusion du nickel et de l'oxygène. Elle doit être mince pour permettre des torsions sans fracture lors de la mise en forme du câble. Elle doit répliquer aussi fidèlement que possible la structure cristalline de la surface du substrat (voir l'article « In situ strain and transport magneto-optical investigations in superconductors » par A. Villaume et al., paru dans la revue Superconductor Science and Technology 21 (2008) 034009). On utilise par exemple des couches minces d'oxyde mixte de lanthane - zirconium $La_2Zr_2O_7$ (voir par exemple le brevet US 6,451,450 (UT-Battelle)), la demande de brevet WO 2008/078852 (Korea Institute of Machinery & Materials), les brevets US 6,537,689 et 7,261,776 (American Superconductor Corp.), et la demande de brevet US 2008/0113869 (V. Selvamanickam). Ce composé peut aussi être déposé de manière non stoechiométrique (voir la demande de brevet US 2008/0039330 (Wolf et al)). On peut aussi utiliser des oxydes d'autres terres rares (samarium, gadolinium, dysprosium, erbium, ytterbium) auxquels s'ajoutent l'yttrium et le scandium, ou plusieurs couches de composition différente, par exemple $La_2Zr_2O_7$ / $CeO_2$, voir US 2007/01977045 (Trithor GmbH) et US 2007/0026247 (UT-Batelle, LLC).

La publication intitulée « La2Zr2O7 single buffer layer for YBaCuO RABiTS coated conductors » (Caroff et al, Supercond. Sci. Technol. 21 (2008) 075007) décrit la préparation par MOD de couches tampon de $La_2Zr_2O_7$ (LZO) de haute qualité sur des substrats métalliques (alliages Ni-5 at.% W) bitexturés par le procédé RABiTS et le dépôt subséquent de couches YBaCuO (de 450 à 800 nm d'épaisseur) par « pulsed injection MOCVD ». conduisant à une architecture simple et peu coûteuse $NiW_{RABiTs}/LZO_{MOD}/YBaCO_{MOCVD}$. Dans cette nouvelle combinaison des procédés MOD et MOCVD, une couche tampon $LZO_{MOD}$ unique est suffisante pour assurer une compatibilité structurale entre YBaCuO et NiW, et protéger le substrat de l'oxydation pendant le dépôt MOCVD de YBaCuO. Les films YBaCuO croissent epitaxialement sur le LZO et possèdent des densités de courant critique $J_c$ proche de 1 MA.cm$^{-2}$ à 77 K avec une température critique $T_c$ de 91 K et un $\Delta7_c$<1 K.

L'article « Growth of thick chemical solution derived pyrochlore La2Zr2O7 buffer layers for YBa2Cu3O7-x coated conductors » par K. Knoth et al. (paru en 2008 dans la revue Thin Solid Films 516, p. 2099-2108) décrit le dépôt de couches LZO à partir de solutions de sels de Zr et La dans l'acide propionique sur des rubans de nickel contenant 5 at-% de tungstène ; l'épaisseur de ces couches est comprise entre 80 nm et 200 nm.

Cependant, tous ces travaux ne concernent que des substrats plats. Or il est peu aisé d'introduire des conducteurs plats dans des câbles de section généralement circulaire. Il serait souhaitable de disposer de conducteurs ronds sous formes de fils pour pouvoir fabriquer des câbles conducteurs électriques, supra-conducteurs à la température de l'azote liquide, permettant le passage de fortes densités de courant, suffisamment flexibles et robustes pour des applications en milieu industriel, et suffisamment simples à fabriquer pour être économiquement viables.

L'article « YBaCuO Thick Films on Planar and Curved Technical Substrates » de H.C. Freyhardt et al., paru en 1997 dans la revue IEEE Transactions on Applied Superconductivity, vol 7 n° 2, p. 1426 - 1431, décrit le dépôt par pulvérisation cathodique de couches de type YSZ (yttria-stabilized zirconia) sur des surfaces planes et cylindriques ; leur surface a été polie par voie mécanique ou électrochimique.

La demande de brevet EP 1 916 720 (Nexans) décrit un procédé pour fabriquer des tubes en métal biaxialement texturé, dans lequel un ruban plat (aussi appelée bande plate) est formé autour d'une âme métallique disposée dans son axe long en tube fendu, les deux chants parallèles étant ensuite soudés l'un contre l'autre sur toute leur longueur par une soudure de type MIG ou TIG ou laser. Ce tube est ensuite étiré pour réduire son diamètre jusqu'à ce que l'âme soit en contact avec toute la paroi interne du tube. Ensuite on dépose une couche de YBaCuO d'une épaisseur comprise entre 1 $\mu$m et 5 $\mu$m à partir d'une phase gazeuse ou liquide suivi d'un traitement thermique. Une couche d'une épaisseur de 100 nm à 200 nm d'oxyde de cérium ou d'oxyde de lanthane - zirconium peut être déposée avant le dépôt de YBaCuO, en utilisant les mêmes techniques que celles employées pour le dépôt de YBaCuO. Cependant, ce document ne contient aucun exemple concret pour la fabrication d'un tel produit, et ne mentionne pas les performances de tels dispositifs.

La demande de brevet US 2008/0119365 d'Arnaud Allais et Nat Dirk décrit un procédé de fabrication d'un conducteur électrique supraconducteur de section circulaire. Le procédé consiste à apporter un support métallique tel qu'un fil, une corde ou un tube d'un diamètre compris entre 0,5 et 3 mm, et de préférence en acier. Une couche métallique est ensuite déposée sur le support métallique, cette couche ayant une épaisseur comprise entre 1 et 20 nm. Le dépôt est réalisé par PVD, CVD, ou CSD (dépôt d'une solution chimique). Le film ainsi déposé est ensuite soumis à un traitement de texturation de manière à ce que dans la mesure du possible tous les grains de cristaux soient alignés (la méthode utilisée pour la texturation n'est pas précisée). Une couche tampon de $La_2Zr_2O_7$ est ensuite optionnellement déposée, par trempage dans une solution d'acide propionique dans laquelle sont dissous de l'acétylacétonate de lanthane et de l'acétylacétonate de zircone. Le liquide déposé sèche et le matériau est soumis à un traitement thermique à 1000°C (la durée du traitement n'étant pas précisée) pour obtenir une couche épitaxiée de $La_2Zr_2O_7$, sur laquelle une couche de YBaCuO est ensuite déposée par épitaxie.

Le problème que la présente invention vise à résoudre est de fournir un procédé de fabrication d'un dispositif supraconducteur long, de section sensiblement circulaire, dans lequel le matériau supraconducteur est une céramique de type YBaCuO, déposée sur la surface externe d'un tube ou fil ou cylindre métallique et ledit procédé incluant le dépôt d'une couche tampon d'oxyde sur la surface externe du tube ou fil ou cylindre métallique préalablement au dépôt de la couche de YBaCuO.

The document "La2Zr2O7 films on Cu-Ni alloy by chemical solution deposition process" by Z. M. Yu et. al. published in MATERIALS SCIENCE AND ENGINEERING B 130 (2006-06-15) pages 126-131 discloses films of La2Zr2O7(=LZO) that have been formed by chemical solution deposition technique (CSD) on new bi-axially textured Cu-Ni alloy tapes based on rolled constantan (Cu55Ni45) Rabits. The precursor used was acetylacetonates treated in propionic acid (0.1-0.87mol/l) and then deposited by spin-coating. The LZO film starts to crystallize above 850 deg. C, the film nucleates biaxially textured on the substrate (with unit cell axis rotated 45 deg. from those of the substrate). The top part of the film is not textured even after long annealing time at 1100 deg. C, but the interfacial part is bi-axially textured.

## Objet de l'invention

Un premier objet de l'invention est un procédé de dépôt d'une couche tampon d'oxyde de métaux épitaxique sur une surface fonctionnalisée d'un substrat métallique texturé, et de préférence un substrat métallique long de section sensiblement circulaire ou elliptique, à texture cube présentant des grains dont la direction [001] est perpendiculaire au sens long du substrat, et dont la direction [100] est parallèle au sens long du substrat, ledit procédé comprenant les étapes suivantes :

(1) on dépose une couche d'un précurseur d'un oxyde de type $(A)_{2-x}B_{2-x}O_7$ où A représente un métal de valence 3 (tel que le La, Y, Gd, Dy, Lu, Sc, Nd, Sa ; le La étant préféré), ou un mélange de plusieurs de ces métaux, et B un métal de valence 4 (tel que le Zr, Ti, Sn, Hf, Pb, Ce ; le Zr étant préféré), tel que le $La_2Zr_2O_7$, (appelé aussi LZO), et x est un nombre compris entre -0,1 et +0,1 , à partir d'une solution des carboxylates (et préférentiellement des propionates) desdits métaux A et B, cette solution ayant une viscosité, mesurée à la température du procédé, comprise entre 1 mPa s et 20 mPa s, et préférentiellement comprise entre 2 mPa s et 10 mPa s,

(2) on laisse sécher ladite couche de précurseur, de préférence à une température comprise entre 60°C et 150°C, et de préférence entre 80 et 100°C.

(3) on effectue un traitement thermique pour pyrolyser ledit précurseur d'oxyde et pour former l'oxyde, au moins une partie dudit traitement thermique étant effectuée sous balayage de gaz réducteur, de préférence Ar + 5%(vol) $H_2$), ledit gaz réducteur ayant de préférence une vitesse de balayage supérieure à 0,005 cm/s, préférentiellement comprise entre 0,012 cm/s et 0,1 cm/s, et encore plus préférentiellement comprise entre 0,04 cm/s et 0,08 cm/s.

Avantageusement, le traitement thermique (étape (3)) comprend une phase dite de pyrolyse et une phase dite de cristallisation. La phase de pyrolyse implique un traitement thermique compris entre 150°C et environ 450°C (et qui ne dépasse de préférence pas 350°C), qui peut être effectué au moins en partie sous pression réduite. La phase de cristallisation implique un traitement thermique compris entre environ 450°C et environ 1100°C, préférentiellement comprise entre 800°C et 1100°C, et préférentiellement entre 850°C et 1000°C, pour former l'oxyde. La phase de cristallisation est effectuée sous balayage de gaz réducteur, comme indiqué ci-dessus.

Avantageusement le traitement thermique comprend une vitesse de montée en température comprise entre 100°C/h et 2000°C/h, préférentiellement entre 250°C/h et 2000°C/h et encore plus préférentiellement entre 500°C/h et 2000°C/h, suivi d'un palier à la température T pendant une durée comprise entre 1 et 120 minutes, préférentiellement entre 10 et 90 minutes, et encore plus préférentiellement entre 20 et 60 minutes, et suivi d'un refroidissement à une vitesse comprise entre 100°C/h et 2000°C/h, préférentiellement entre 100°C/h et 1000°C/h et encore plus préférentiellement entre 100°C/h et 500°C/h.

Un deuxième objet de l'invention est l'utilisation de ce procédé dans un procédé de fabrication de dispositifs supraconducteurs comportant une couche supraconductrice d'oxyde mixte terre rare - baryum - cuivre (TRBaCuO) ou d'oxyde mixte yttrium - baryum - cuivre (YBaCuO ou YBCO), ladite couche supraconductrice étant déposé sur ladite couche tampon.

Un troisième objet de l'invention est un procédé de fabrication d'un conducteur électrique supraconducteur de section transversale sensiblement circulaire ou elliptique, ledit conducteur comportant une couche d'oxyde mixte terre rare - baryum - cuivre (TRBaCuO) ou d'oxyde mixte yttrium - baryum - cuivre (YBaCuO ou YBCO) en tant que matériau supraconducteur déposée sur un substrat métallique de section sensiblement circulaire, ledit procédé comportant, dans l'ordre indiqué, les étapes suivantes :

(a) on approvisionne un substrat métallique long de section sensiblement circulaire ou elliptique, et typiquement un substrat tubulaire, ledit substrat ayant une texture cube présentant des grains dont la direction [001] est perpendiculaire à l'axe cylindrique du substrat ;

(b) on effectue un traitement de fonctionnalisation au moins de la surface externe dudit substrat métallique, de préférence par un traitement au $H_2S$ ;

(c) on dépose une couche tampon d'oxyde métallique épitaxique au moins sur la surface externe fonctionnalisée dudit tube à partir d'une solution liquide, en utilisant le procédé qui correspond au premier objet de la présente invention ;

(d) on dépose la couche de TRBaCuO ou de YbaCuO, sur la couche d'oxyde métallique déposée à l'étape (c) ;

(e) on dépose une couche de protection en métal, de préférence en argent ;

(f) on effectue un traitement oxydant.

Un dernier objet de l'invention est un conducteur électrique supraconducteur de section transversale sensiblement circulaire ou elliptique susceptible d'être obtenu par le procédé précité.

## Description des figures

Les figures 1 à 5 se rapportent à la présente invention.

La figure 1 montre des images microscopiques de la surface d'un substrat revêtu d'une couche tampon de LZO selon l'invention. La longueur de la barre représente 10 μm.

La figure 2 montre un schéma de tube texturé selon l'invention. Les axes de texture sont indiqués : l'axe parallèle au sens long du tube, et un axe radial au tube (i.e.

perpendiculaire au sens long du tube).

La figure 3 montre une courbe de la résistance électrique en fonction de la température pour un produit fabriqué selon le procédé de l'invention. L'axe horizontal est gradué en Kelvin, l'axe vertical en Ohm.

La figure 4 montre un tube à aspiration différentielle utilisé pour le traitement thermique de la couche tampon selon un mode de réalisation de l'invention. Les repères suivants sont utilisés sur cette figure :

1 - Espace extérieur ; 2 - Espace intérieur ; 3 - Paroi perforée

4 - Direction de l'aspiration ; 5 - Direction de l'entrée de gaz

6 - Produit à traiter

Les flèches indiquent une direction d'écoulement de gaz.

La figure 5 montre la forme d'un substrat courbé, texturé biaxialement. Ce substrat a une forme « gondolée » ou « nervurée ».

## Description de l'invention

La présente invention concerne un procédé de fabrication d'un conducteur électrique supraconducteur comportant une couche de céramique de type $(TR)Ba_2Cu_3O_{7-x}$ (où TR symbolise un ou plusieurs éléments de terre rare ; ce composé étant appelé ici, indépendamment de sa stoeichiométrie, « TRBaCuO ») ou de type $YBa_2Cu_3O_{7-x}$ (appelé ici, indépendamment de sa stoeichiométrie, « YBaCuO »), de type $Bi_2Sr_2Ca_2Cu_3O_{10+y}$, de type $Tl_2Ba_2Cu_2Cu_3O_{10+y}$, ou de type $HgBa_2Ca_2Cu_3O_{8-y}$ en tant que matériau supraconducteur déposée sur un substrat métallique texturé. Elle concerne notamment un procédé de fabrication d'un conducteur électrique supraconducteur comportant une couche d'oxyde mixte d'yttrium - baryum - cuivre (YBaCuO ou YBCO, cette désignation étant indépendante de la stoeichiométrie de la formule).

Dans un mode de revendication avantageux de l'invention, le procédé comporte, dans l'ordre indiqué, les étapes suivantes :

(i) on approvisionne un substrat métallique long de section sensiblement circulaire ou elliptique, et typiquement un substrat tubulaire, ledit substrat ayant une texture cube présentant des grains dont la direction [001] est perpendiculaire au sens long du substrat, et dont la direction [100] est parallèle au sens long du substrat ;

(ii) on effectue un traitement de fonctionnalisation au moins de la surface externe dudit substrat métallique, de préférence par un traitement au $H_2S$ ;

(iii) on dépose une couche tampon d'oxyde de métaux épitaxique au moins sur la surface externe fonctionnalisée dudit tube à partir d'une solution liquide ;

(iv) on dépose la couche de TRBaCuO ou de YbaCuO. sur la couche d'oxyde métallique déposée à l'étape (iii) ;

(v) on dépose une couche de protection en métal, de préférence en argent ;

(vi) on effectue un traitement oxydant ;

ledit procédé étant caractérisé en ce que :

à l'étape (iii),

(a) on dépose une couche d'un précurseur d'un oxyde de type $A_{2-x}B_{2+x}O_7$ où A représente un métal de valence 3 (tel que le La, Y, Gd, Dy, Lu, Sc, Nd, Sa ; le La étant préféré) ou un mélange de plusieurs de ces métaux, et B un métal de valence 4 (tel que le Zr, Ti, Sn, Hf, Pb, Ce ; le Zr étant préféré), tel que le $La_2Zr_2O_7$,(appelé aussi LZO), et x est un nombre compris entre -0,1 et +0,1, à partir d'une solution des propionates (carboxylates) desdits métaux A et B, cette solution ayant de préférence une viscosité, mesurée à la température du procédé, comprise entre 1 mPa s et 20 mPa s, et encore plus préférentiellement comprise entre 2 mPa s et 10 mPa s,

(b) on laisse sécher ladite couche de précurseur, de préférence à une température comprise entre 80 et 100°C,

(c) on effectue un traitement thermique à une température T comprise entre 800°C et 1100°C, et préférentiellement entre 850°C et 1000°C, pour former l'oxyde, ce traitement thermique étant effectué :

- avec une vitesse de montée en température comprise entre 100°C/h et 2000°C/h, préférentiellement entre 250°C/h et 2000°C/h et encore plus préférentiellement entre 500°C/h et 2000°C/h, suivi d'un palier à la température T pendant une durée comprise entre 1 et 120 minutes, préférentiellement entre 10 et 90 minutes, et encore plus préférentiellement entre 20 et 60 minutes, et suivi d'un refroidissement à une vitesse comprise entre 100°C/h et 2000°C/h, préférentiellement entre 100°C/h et 1000°C/h et encore plus préférentiellement entre 100°C/h et 500°C/h ;

- sous balayage de gaz réducteur, de préférence Ar + 5%(vol) $H_2$), ledit gaz réducteur ayant de préférence une vitesse de balayage supérieure à 0,005 cm/s, préférentiellement comprise entre 0,012 cm/s et 0,1 cm/s, et encore plus préférentiellement comprise entre 0,04 cm/s et 0,08 cm/s.

Selon l'invention, à l'étape (ii) :

on effectue avantageusement un traitement de fonctionnalisation du substrat métallique par un procédé comportant les étapes de :

- traitement sous vide (un vide d'environ $10^{-3}$ bar convient) avec une vitesse de montée en température de 800°C/h, avec un palier à 600°C pendant une durée d'au moins 1 minute et de préférence comprise entre 10 et 60 minutes (avantageusement pendant environ 30 minutes), suivi d'un refroidissement jusqu'à température ambiante,

- traitement de fonctionnalisation, de préférence par balayage de gaz inerte (Ar) avec 0,1%(vol) $H_2S$ à la température ambiante et à une pression comprise entre $10^{-3}$ bar et 10 bar, préférentiellement à la pression atmosphérique, pendant une durée d'au moins 1 minute, et avantageusement d'environ 30 minutes,

- traitement sous balayage de gaz réducteur Ar + 5%(vol) $H_2$ avec une vitesse de montée en température de 800°C/h, avec un palier à 850°C pendant 30 minutes, suivi d'un refroidissement jusqu'à température ambiante.

Nous décrivons ici en détail chacune des étapes.

(i) Approvisionnement d'un substrat métallique

Le procédé selon l'invention peut s'appliquer à des substrats métalliques texturés plats ou courbés, et notamment à des substrats de section sensiblement circulaire ou elliptique. Ces substrats peuvent être tubulaires. Ils doivent être en un métal qui cristallise dans une structure de type CFC (cubique à faces centrées). Ils peuvent être en nickel ou en nickel allié au tungstène, et doivent posséder une texture cube {100}<100>. Des substrats tubulaires qui conviennent pour la réalisation de l'invention peuvent être fabriqués par un procédé de soudage des chants dans lequel un ruban plat (aussi appelée bande plate) est formé autour d'une âme métallique disposée dans son axe long en tube fendu, les deux chants parallèles étant ensuite soudés l'un contre l'autre sur toute leur longueur par une soudure de type MIG ou TIG. La soudure par laser est également possible ; elle n'entraîne aucun risque de pollution si elle procède sans métal d'apport. Ce tube est ensuite étiré pour réduire son diamètre jusqu'à ce que l'âme soit en contact avec toute la paroi interne du tube. D'autres procédés peuvent convenir pour obtenir ces substrats texturés de section sensiblement circulaire ou elliptique.

Sur ces substrats métalliques texturés biaxialement, de préférence de section transversale sensiblement circulaire ou elliptique, et notamment sur des tubes, on réalise successivement des traitements de fonctionnalisation du substrat métallique, de dépôt chimique d'un précurseur de la couche tampon, de traitement thermique, en vue d'obtenir une couche tampon constituée d'un film d'oxyde, le plus dense possible et hypertexturé. On utilise pour cela la croissance par épitaxie sur les grains du substrat. On part d'un précurseur métal-organique mouillant qui permet d'effectuer le dépôt qui est séché puis traité thermiquement pour synthétiser l'oxyde.

Préalablement à la fonctionnalisation du substrat en vue du dépôt de la couche tampon, le substrat métallique doit être dégraissé. Avantageusement, cela est fait en deux temps : d'abord à l'aide d'acétone (de préférence dans un bain soumis aux ultrasons), puis à l'aide d'un alcool, tel que le méthanol, l'éthanol, des butanols ou hexanols (le méthanol étant préféré car son évaporation ne laisse aucune trace).

(ii) Fonctionnalisation du substrat

Préalablement au dépôt du précurseur métal-organique de la couche tampon LZO, le substrat doit avoir été fonctionnalisé. La fonctionnalisation du substrat métallique a deux objectifs : un premier objet est d'assurer une couche d'adaptation permettant la liaison de l'oxyde LZO sur le métal : il s'agit de créer des sites cristallographiques sur le métal susceptibles de se lier à ceux de l'oxyde. Ainsi on obtient une couche qui reproduit la structure atomique du substrat (i.e. l'épitaxie).

La fonctionnalisation a également pour objet de créer une surface chimiquement stable, car cette surface sera forcément exposée à la pression ambiante lorsque le substrat sera trempé dans la solution pour déposer la couche tampon.

Cette étape est essentielle pour permettre une liaison chimique des atomes de l'oxyde à ceux du métal.

En pratique, la fonctionnalisation du substrat est réalisée de préférence par un traitement de surface, consistant en un dépôt d'une ou plusieurs monocouches de soufre. On sait que le soufre forme une couche chimisorbée ordonnée sur les métaux à structure cristallographique CFC (cubique face centrée) généralement utilisés comme substrats. Cette couche de soufre peut être obtenue par un traitement thermique approprié, et avantageusement par un procédé comportant les étapes de :

- traitement sous vide (un vide primaire, i.e. de l'ordre de $10^{-3}$ bar, suffit) avec une vitesse de montée en température comprise entre 600°C/h et 1000°C/h (et de préférence d'environ 800°C/h), suivi d'un palier à une température comprise entre 550°C et 650°C (de préférence à environ 600°C) pendant environ 30 minutes, puis d'un refroidissement jusqu'à température ambiante,

- balayage de gaz inerte (Ar) avec environ 0,1 %(vol) $H_2S$ à température ambiante pendant environ 30 minutes, à la pression atmosphérique ;

- traitement sous balayage de gaz réducteur, de préférence Ar + 5%(vol) $H_2$, avec une vitesse de montée en température comprise entre 600°C/h et 1000°C/h (et de préférence d'environ 800°C/h), suivi optionnellement d'un palier à une température comprise entre 750°C et 900°C (de préférence à environ 850°C) pendant environ 30 minutes, puis d'un refroidissement jusqu'à température ambiante.

Le contrôle de cette couche peut être fait par des techniques d'analyse de surface connues de l'homme du métier pour cet usage, comme l'Auger, le RHEED.

Le traitement de sulfuration est connu dans son principe : on dépose sous ultravide une monocouche de soufre, comme suggéré dans l'article "RHEED Studies of Epitaxial Oxide Seed-Layer Growth on RABiTS Ni(001) : The Role of Surface Structure and Chemistry", par C. Cantoni et al., (disponible sur le serveur d'internet [cond-mat.supr.con], arXiv :cond-mat/0106254v1). Ce procédé n'a pas été exploité, à la connaissance des inventeurs, à une pression atmosphérique ou de vide primaire pour fonctionnaliser un substrat cylindrique destiné à recevoir une couche de LZO déposée par voie liquide. -

Un procédé de dépôt de soufre sur le substrat avant dépôt de la couche YBaCuO à pression atmosphérique est décrit également dans les demandes de brevet de la société American Superconductor Corp., US 2007/0197395 (mais dans ce document, une couche tampon métallique ou oxydique autre que LZO est déposée au-dessus de cette couche de soufre, avant dépôt de la couche YBaCuO) et US 2007/0179063.

Alternativement, on peut utiliser pour le traitement de fonctionnalisation un composé soufré, tel qu'un sulfure organique ; cependant, le carbone risque de gêner la fonctionnalisation de surface. On peut aussi traiter la surface aux vapeurs de soufre, mais c'est difficile à doser. Compte tenu de la disponibilité et de la simplicité de la molécule $H_2S$, ce traitement est préféré.

On peut aussi fonctionnaliser la surface par la création d'une monocouche d'oxygène.

Le résultat du procédé de fonctionnalisation est une couche de fonctionnalisation stable à l'air pendant la durée nécessaire pour transférer le substrat dans la phase liquide pour épitaxie.

Dans le cas où le substrat métallique contient du soufre, il est possible d'utiliser la couche de surface qui se forme par ségrégation à la suite de certains traitements thermiques du métal, qui tiennent alors lieu de traitement de fonctionnalisation. La ségrégation ayant lieu lors du refroidissement, c'est le refroidissement qui doit être soigneusement contrôlé. Dans certains cas, le recuit de texturisation peut ainsi comprendre le recuit de fonctionnalisation.

(iii) <u>Dépôt de la couche tampon</u>

Le dépôt de la couche tampon est une caractéristique essentielle de la présente invention. La couche est obtenue par dépôt chimique en solution suivi d'un traitement thermique. Cette couche tampon est primordiale car c'est sur celle-ci qu'est dupliquée la texture de la couche YBaCuO qui, si elle est correcte, permettra le passage de grandes densités de courant de courant électrique. Une couche tampon optimale reproduit d'une part la texture du substrat et constitue d'autre part une barrière efficace à la diffusion. Une couche constitue une barrière efficace à la diffusion en particulier si elle est dense ou ne présente qu'une faible porosité formée de petits trous non connectés.

La couche tampon déposée dans le cadre de la présente invention est un oxyde de type $A_{2-x}B_{2+x}O_7$ où A est un métal de valence 3 (tel que le La ou un lanthanide, tel que Gd, Dy, Lu, Nd, Sa, ou le Sc ; le La étant préféré) et B un métal de valence 4 (tel que le Zr, Ti, Sn, Hf, Pb, Ce, Ta ; le Zr étant préféré), tel que le $La_2Zr_2O_7$ (appelé aussi LZO), et x est un nombre compris entre -0,1 et +0,1. Elle est très préférentiellement un oxyde mixte de lanthane et zircone de composition nominale $La_2Zr_2O_7$ (LZO). En effet, il a été montré récemment (Caroff et al, Sup.Sci.Technol. 2008, 21 075007) qu'il était possible, sur des substrats plats, de n'avoir qu'une seule couche tampon de LZO, ce qui est très économique. On peut utiliser d'autres oxydes que LZO, tels que par exemple $SrTiO_3$, $LaMnO_3$, YSZ, mais alors il faut une architecture en général complexe car très peu d'oxydes arrivent à satisfaire toutes les fonctions des tampons en une fois. C'est pourquoi on préfère largement les couches de type $A_{2-x}B_{2+x}O7$ et plus spécialement le LZO. En particulier, si une couche tampon composée de plusieurs couches est envisagée, les inventeurs préfèrent utiliser une telle couche LZO en contact avec le substrat métallique. Mais ils préfèrent une couche homogène, appliquée en une seule fois.

Dans la formule $A_{2-x}B_{2+x}O_7$, A peut représenter aussi plusieurs éléments métalliques de valence 3, et B peut représenter plusieurs éléments métalliques de valence 4. A titre d'exemple, dans une couche de type LZO, on peut substituer au moins partiellement les atomes de La par des atomes de Gd. On peut aussi déposer au-dessus d'une première couche mince de LZO une seconde couche de GZO (gadolinium-zirconiumoxyde).

Les inventeurs ont montré qu'une bonne qualité de couche tampon (et notamment une couche de LZO déposée comme décrit ci-dessous) permet de simplifier énormément l'architecture des supraconducteurs déposés. Ainsi la structure multicouche Ni5W/LZO/YBa-CuO/protection(Ag) déposée sur un substrat plat permet de faire passer près de 1 MA/cm² à 77°K alors que les solutions de l'état de la technique proposent jusqu'à 10 couches tampon pour parvenir au même résultat. Le procédé selon l'invention permet en particulier d'utiliser un seul type de couche tampon, et de ce fait, il est plus simple que les procédés connus. En particulier, le procédé selon l'invention permet de déposer une telle couche sur un substrat courbé, par exemple sur un tube, de manière à obtenir par la suite une couche supraconductrice à la température de l'azote liquide, ce qui ne semble pas être possible avec les procédés selon l'état de la technique.

L'obtention d'une couche tampon de bonne qualité selon le procédé de l'invention fait intervenir de multiples facteurs.

*(1) Précurseur*

La décomposition du précurseur doit donner un oxyde. Dans la présente invention, on utilise de préférence des carboxylates dans lesquels le cation est coordonné à des oxygènes. Ils permettent donc la formation d'oxydes, même dans des conditions réductrices évitant l'oxydation du métal substrat. L'avantage des carboxylates est leur stabilité vis-à-vis de l'humidité de l'atmosphère. Le précurseur est déposé par voie liquide, et en particulier par trempage. Parmi les carboxylates, on préfère les propionates.

Pour obtenir une couche de LZO, le précurseur utilisé dans la présente invention est une solution à 0,6 mol/l de LaZr(prop)$_7$ (La / Zr = 1 :1, i.e. la solution contient 0,3 mol/l de La et 0,3 mol/l de Zr) dans l'acide propionique. LaZr(prop)$_7$ est de préférence préparé par attaque dans l'acide propionique de La(acac)$_3$ x 3 H$_2$O et Zr(acac)$_4$ (où « acac » désigne l'acétylacétonate) séparément, en chauffant légèrement (typiquement à environ 60°C), sans évaporer une quantité significative d'acide propionique. La concentration maximale de LaZr(prop)$_7$ utilisable semble être 0,9 mol/l.

Pour obtenir d'autres couches de type $A_{2-x}B_{2+x}O_7$, on utilise avantageusement également les carboxylates, et de manière encore plus préférée les propionates des métaux A et B. A titre d'exemple, pour introduire le gadolinium dans une composition pour déposer une couche de Gd$_2$Zr$_2$O$_7$ (GZO), on utilise avantageusement le propionate de gadolinium.

*(2) Viscosité*

La viscosité $\eta$ de la solution est un paramètre très important car elle conditionne l'épaisseur déposée après trempage.

La viscosité de solutions de propionate de métaux, et notamment celle de solutions de propionate de LZO (LaZr(prop)7), dans l'acide propionique dépend de la concentration de la solution. On sait (voir par exemple Knoth et al, Sup. Sci.Technol. 18(2005), p. 334-339) que la viscosité d'une solution de 0,05 mol/l vaut 1,5 mPas, 2,5 pour 0,15 mol/l, et 6,5 mPas pour une concentration de 0,3 mol/l. L'épaisseur déposée après la trempe d est donnée par l'équation de Landau - Levich :

$$ d = a \frac{(\eta v)^{2/3}}{\gamma^{1/6}(\rho g)^{1/2}} $$

où y est la tension de surface liquide-vapeur, p la densité du liquide et v la vitesse de retrait hors du bain, et a est un paramètre numérique qui vaut environ 0,94.

Des adjuvants tels que des composés plurifonctionnalisés, sélectionnés par exemple parmi les polyamines, les polyamides, les polyéthers, les aminoalcools, ou de véritables polymères, comme par exemple le polyméthacrylate de méthyle (PMMA), le polyéthylène glycol (PEG), l'alcool polyvinylique (PVA), peuvent être ajoutés à la solution de propionates pour épaissir la solution et augmenter l'épaisseur déposée.

D'autre part, l'épaisseur du dépôt de précurseur dépend également de la température du bain. L'élévation de la température de quelques degrés peut modifier de plusieurs dizaines de % l'épaisseur finale d'oxyde obtenu après traitement thermique. On préfère ne pas dépasser 40°C, et encore plus préférentiellement ne pas dépasser 30°C. Au-dessus de 40°C, la composition de la solution se modifié dû à l'évaporation du solvant (typiquement d'acide propionique si on utilise des propionates). Une température trop basse du bain est susceptible de conduire à un début de cristallisation d'une des espèces présentes dans le bain. Par conséquent, on préfère une température comprise entre 20°C et 30°C. La viscosité de la solution précurseur à la température du procédé est comprise entre 1 mPa s et 20 mPa s, et préférentiellement comprise entre 2 mPa s et 10 mPa s. Cette mesure est effectuée de manière classique par un viscosimètre à bille.

Le procédé selon l'invention fait intervenir un substrat de forme cylindrique, tel qu'un tube. Le dépôt se fait par trempage. Lorsque l'on retire le substrat du liquide, celui-ci s'écoule mais une pellicule reste déposée, dont l'épaisseur est régie par la loi écrite plus haut. La géométrie cylindrique du substrat modifie les écoulements par rapport à la géométrie plane, en particulier à cause des effets de bords qui sont différents.

*(3) Séchage*

Le séchage permet d'obtenir une couche solide qui a l'aspect d'une résine polymérique. Elle rend l'objet manipulable aisément. Pour obtenir cette couche, la couche de précurseur déposée par voie liquide est séchée, de préférence à une température comprise entre 80°C et 100°C, avantageusement par un chauffage infrarouge. Ce séchage conduit à la polymérisation au moins partielle de la résine, attestée par le fait que le précurseur devient rigide et seulement partiellement soluble dans les solvants usuels. On peut également sécher cette couche par un flux de gaz neutre chaud (argon ou azote par exemple), de préférence à une température comprise entre 60°C et 150°C.

Les étapes de trempe et séchage/polymérisation sont faites dans une atmosphère contrôlée. Cela implique, d'une part, la protection contre des poussières qui viendraient faire des « pailles » dans le film. Cela implique également un contrôle soigneux du taux d'humidité, afin que le procédé soit reproductible. Un taux d'humidité relative de 20% convient. Un taux plus faible peut également convenir.

*(4) Epaisseur déposée*

L'épaisseur déposée dépend de la vitesse d'extraction, de la viscosité et de la tension de surface liquide - vapeur. La vitesse d'extraction, c'est-à-dire la vitesse avec laquelle le substrat est extrait du liquide, se situe avantageusement entre 1 mm/min et 100 mm/min, et est de préférence d'au moins 10 mm/min. En général, la gamme d'épaisseur optimale de LZO, compte tenu des propriétés du supraconducteur qui le recouvre ensuite, se situe entre 30 nm et 250 nm. Les inventeurs ont pu déposer sur des surfaces courbées, et notamment sur des tubes d'un diamètre de quelques millimètres, jusqu'à 250 nm de LZO, en plusieurs dépôts successifs, sans craques et avec des qualités de textures correctes, bien que ces couches ne soient pas toujours cristallisées en surface comme requis. A condition d'avoir des qualités de texture et de cristallisation correctes, il est préférable d'avoir une couche tampon dont non seulement la densité, mais aussi l'épaisseur soit élevée, dans les limites indiquées ci-dessus. En effet, les inventeurs ont trouvé que les propriétés de la couche supraconductrice TRBa-

CuO ou YBaCuO, sont meilleures pour les plus fortes épaisseurs de LZO. Une explication pourrait être que les défauts de surface du substrat sont davantage masqués avec des couches tampon épaisses. On préfère une épaisseur comprise entre 60 nm et 250 nm, et encore plus préférentiellement comprise entre 80 nm et 250 nm. En effet, le procédé selon l'invention permet de déposer une épaisseur comprise entre 30 nm et environ 120 nm en une seule fois, sans formation de craquelures. Une épaisseur typique déposée en une fois est 80 nm. Le dépôt de plusieurs couches l'une sur l'autre, ces couches étant de composition identique, donne une meilleure densification de la couche tampon obtenue. La couche déposée, en un seul dépôt ou en plusieurs dépôts successifs, est texturée bi-axialement.

Le procédé selon l'invention diffère des procédés sur substrat plat par la texture du substrat. Dans les rubans plats, la texture est tridimensionnelle et présente deux directions orthogonales préférentielles. Ceci signifie que les grains sont orientés les uns par rapport aux autres dans le plan et perpendiculairement au plan. Si on roule ce ruban pour en faire un tube, on va mécaniquement introduire des désorientations radiales entre grains, et créer des contraintes de surface. La désorientation radiale moyenne entre grains peut être calculée si l'on connaît le nombre de grains sur 360°. Un substrat sous la forme d'un tube, tel qu'utilisé dans le cadre de la présente invention, présente typiquement une taille moyenne de grains de 50 $\mu$m, observée sur une zone d'un diamètre de 2 mm, ce qui conduit à une désorientation radiale moyenne entre grain d'environ 3° ; cela est acceptable. Un tel substrat présente une texture bidirectionnelle avec un axe radial et un axe axial. Sa couche d'oxyde présente typiquement une taille de grain comprise entre 50 nm et 80 nm.

*(5) Traitement thermique*

Cette étape est particulièrement critique pour le procédé selon l'invention. Après séchage, le film est porté à une température comprise entre 850 et 1100°C avec une vitesse de montée en température comprise entre 100 et 2000°C/h sous un balayage de gaz réducteur, de préférence un mélange d'argon contenant 5 vol-% $H_2$. L'utilisation d'un tel gaz évite l'oxydation du substrat. Il peut être utile d'effectuer un palier à haute température.

Le flux et le débit de gaz, la vitesse de montée en température et la température de traitement (température maximum) sont des paramètres essentiels de la phase du traitement thermique. La vitesse de gaz doit être la plus élevée possible, sans risquer de refroidir l'échantillon et elle conditionne le déroulement de la pyrolyse des précurseurs, notamment l'avancement du front de pyrolyse, et l'avancement du front de cristallisation de la partie texturée dans le film.

La température du traitement thermique est avantageusement comprise entre 800°C et 1100°C pour former l'oxyde. Elle doit être supérieure à 850°C pour amorcer une cristallisation, et doit être inférieure à la température de recristallisation du substrat sous peine de le voir perdre sa texture. La température optimale dépend du substrat. Pour les substrats de Ni - 5at%W, la température de recristallisation se situe avantageusement proche de 1100°C. Une température trop élevée, et un traitement trop long à température élevée, peut favoriser l'interdiffusion entre le substrat métallique et la couche tampon. En particulier, le tungstène du substrat en nickel - tungstène peut diffuser dans la couche tampon, et le lanthane de la couche tampon peut diffuser dans le substrat métallique. Il peut aussi y avoir des réactions à l'interface. La température de cristallisation optimale dépend légèrement de la composition en éléments métalliques de la couche. Les valeurs données ci-dessus sont optimales pour le LZO. Un dopage au Gd peut inciter à baisser légèrement cette température.

En tout état de cause, le traitement thermique se fait avantageusement avec une vitesse de montée en température comprise entre 100°C/h et 2000°C/h, préférentiellement entre 250°C/h et 2000°C/h et encore plus préférentiellement entre 500°C/h et 2000°C/h, suivi d'un palier à la température T pendant une durée comprise entre 1 et 120 minutes, préférentiellement entre 10 et 90 minutes, et encore plus préférentiellement entre 20 et 60 minutes, et suivi d'un refroidissement à une vitesse comprise entre 100°C/h et 2000°C/h, préférentiellement entre 100°C/h et 1000°C/h et encore plus préférentiellement entre 100°C/h et 500°C/h.

Dans un mode de réalisation particulier, le traitement thermique peut être effectué en deux parties ou phases se distinguant par leur domaine de température : une première partie ou phase dite de pyrolyse, allant d'environ 150°C à environ 350°C, et une seconde partie ou phase dite de cristallisation, allant d'environ 450°C à environ 1000°C ou 1100°C. Les vitesses de montée en température à l'intérieur de ces deux régimes peuvent être différentes, par exemple lent en phase de pyrolyse et rapide en phase de cristallisation.

De manière avantageuse, le traitement thermique fait intervenir un passage sous vide dans le domaine de la pyrolyse. A la fin de la phase de pyrolyse, on peut laisser refroidir jusqu'à la température ambiante, ou on peut continuer le traitement thermique en augmentant la température pour arriver dans la phase de cristallisation.

Par ailleurs, le traitement thermique pendant la phase de cristallisation doit se faire sous balayage de gaz réducteur, de préférence Ar + 5%(vol) $H_2$), ledit gaz réducteur ayant de préférence une vitesse de balayage supérieure à 0,005 cm/s, préférentiellement comprise entre 0,012 cm/s et 0,1 cm/s, et encore plus préférentiellement comprise entre 0,04 cm/s et 0,08 cm/s. On peut aussi utiliser un mélange de $N_2$ + $H_2$ (typiquement 5% vol. $H_2$) qui est moins cher qu'un mélange Ar + $H_2$.

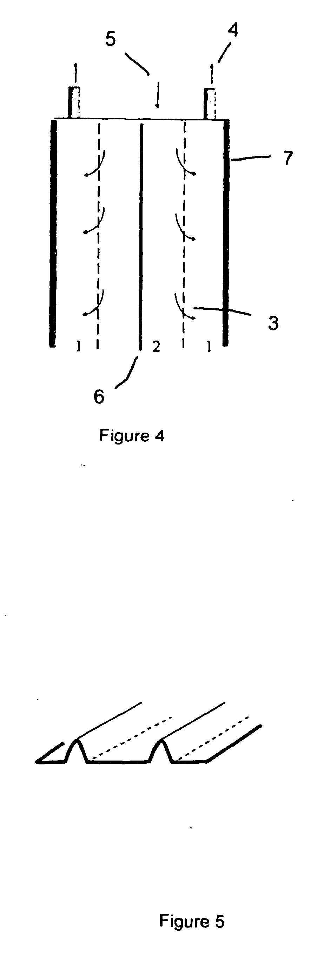

Dans un mode de réalisation avantageux de l'invention, ce balayage de gaz est effectué en injectant le gaz préchauffé à contre-courant dans un tube dit à aspiration différentielle, qui est montré schématiquement sur la figure 4. Il comporte une paroi chauffante (7) et des parois internes perforées (3) qui délimitent un espace intérieur (2) et un espace extérieur (1). Le produit à traiter (6) se trouve dans l'espace intérieur (2). Le gaz entre (4) dans le tube, entraîne les produits gazeux de la réaction de pyrolyse et est extrait à l'extérieur du tube par une aspiration (4) à travers les parois perforées (3). La pression dans l'espace intérieur (2) est supérieure à celle dans l'espace extérieur (1).

Le balayage de gaz peut aussi être appliqué pendant la phase de pyrolyse, si l'on ne choisit pas d'effectuer la pyrolyse, comme indiqué ci-dessus, sous vide.

Dans un mode de réalisation typique, la phase de pyrolyse est effectuée à 350°C sous vide primaire pendant 1 heure (minimum 30 minutes), pour éliminer les résidus de l'acide propionique, et la phase de cristallisation est effectuée sous balayage d'argon/$H_2$ comme décrit ci-dessus.

La croissance de la partie épitaxiée qui démarre de l'interface par nucléation hétérogène sur le substrat doit s'étendre jusqu'à la surface pour permettre une reprise d'épitaxie pour le dépôt d'une couche TRBaCuO ou YBaCuO de bonne qualité. Or, les propriétés des films d'oxyde tampon obtenus par voie chimique font que la nucléation peut aussi se produire dans la partie non épitaxiée par nucléation en phase homogène, les grains germant alors dans des directions aléatoires. Il est indispensable d'éviter cette nucléation en phase homogène afin que le film soit texturé dans toute son épaisseur, jusqu'à la surface.

sangs vouloir s'enfermer dans cette hypothèse scientifique, les inventeurs pensent que le carbone et les espèces carbonées, et peut-être aussi l'oxygène et les composés carbonés qui l'emportent, générés par la pyrolyse du précurseur métal-organique, jouent un rôle important dans ce processus et bloquent peut-être la nucléation et la croissance homogène, permettant ainsi à la partie texturée de s'étendre facilement jusqu'à la surface.

De même, les inventeurs s'imaginent que le balayage du gaz de conditionnement passant au dessus du film lors de son traitement thermique agit sur la cinétique de la pyrolyse des précurseurs et gère l'avancée du front de croissance de la partie texturée. Cette hypothèse permettrait d'expliquer pourquoi la vitesse de recuit joue un rôle important dans la pyrolyse, la nucléation et la cristallisation, et détermine donc, pour une part, la microstructure du film céramique constituant la couche tampon.

De manière surprenante, les inventeurs ont constaté que dans le procédé selon l'invention, la nucléation se fait par épitaxie sur les grains du substrat métallique, conduisant à une couche épitaxique d'excellente qualité, c'est-à-dire cristallisée, texturée en surface et dense, qui permet de déposer ensuite des couches TRBaCuO ou YBaCuO de très bonne qualité. L'obtention par ce procédé d'une couche epitaxique courbée qui est texturée en surface est surprenante, car toute désorientation des grains du substrat risque de se traduire sur les grains ayant nucléés. C'est un des problèmes spécifique à la géométrie non plane ; le procédé selon l'invention permet de résoudre ce problème. Le fait que la couche LZO soit texturée en surface permet à la couche TRBaCuO ou YBaCuO de reprendre cette texture lors de son dépôt par épitaxie ; on obtient ainsi une couche TRBaCuO ou YBaCuO de structure contrôlée qui présente d'excellentes propriétés supraconductrices. C'est donc sur des substrats non plans (i.e. courbés) que le procédé selon l'invention est particulièrement avantageux par rapport aux procédés connus.

(iv) Dépôt de la couche de TRBaCuO

Le substrat recouvert de sa couche tampon est ensuite recouvert d'une couche supraconductrice de TRBaCuO ou YBaCuO et enfin d'une couche protectrice fine par pulvérisation d'Ag. Cette couche supraconductrice est avantageusement une couche d'YBaCuO. Dans un mode de réalisation, son épaisseur est comprise entre 200 nm et 500 nm.

Le dépôt de la couche TRBaCuO ou YBaCuO se fait de préférence par la technique de MOCVD (metal-organic chemical vapour deposition), que l'homme du métier connaît en tant que telle. Une technique de dépôt d'YBaCuO par MOCVD qui convient est décrite par exemple dans la demande de brevet WO 93/08838 et dans l'article publié par Donet et al. dans J. Phys IV Pr 11 AA 319 en 2001.

On peut utiliser avantageusement une technique MOCVD à injection périodique de gouttelettes telle que décrite dans les documents WO 95/02711 et US 5,945,162 précités, qui permet de synthétiser des couches minces de matériaux complexes de type TRBaCuO avec un très bon contrôle de la stoechiométrie, de la vitesse de croissance et de la qualité cristalline des films. Son principe repose sur l'utilisation d'une micro-vanne à commande électronique qui permet d'introduire des volumes liquides très précisément contrôlés d'une solution composé de précurseurs organométalliques et d'un solvant. La solution est contenue dans un flacon pressurisé sous atmosphère inerte et connecté à l'injecteur. Des microgouttelettes sont injectées séquentiellement dans un évaporateur (à une température d'environ 250°C) où le solvant et les précurseurs sont vaporisées. Un flux gazeux transporte les précurseurs dans la zone de réaction où la croissance CVD a lieu sur un substrat chauffé. On peut ainsi injecter soit des gouttelettes constituées de mélanges de plusieurs précurseurs, soit successivement des gouttelettes constitué d'un seul précurseur. Cette technique permet le dépôt de couches de composition chimique complexe.

Pour déposer de manière homogène sur un substrat de forme cylindrique, on peut utiliser par exemple plusieurs rangs de buses reparties autour du cylindre, ou on peut faire tourner le substrat cylindrique autour de son axe long devant une pluralité de buses. On peut utiliser par exemple 16 buses réparties sur une longueur de 30 cm.

(v) Dépôt d'une couche métallique

Au-dessus de la couche TRBaCuO ou YBaCuO, on dépose ensuite une couche métallique. Cette couche est de préférence perméable pour l'oxygène, permettant sa diffusion. L'argent donne le meilleur résultat. Cette couche peut être déposée avec toute technique connue, mais on préfère le dépôt dans des conditions permettant l'absence de contaminations d'interface empêchant le transfert de courant entre la couche protectrice d'argent et la couche supraconductrice. Le nettoyage de l'interface peut se faire par exemple par un plasma d'argon-oxygène.

Dans un mode de réalisation, on dépose une couche d'argent d'une épaisseur comprise entre 250 nm et 450 nm.

(vi) Traitement oxydant

Le traitement oxydant est nécessaire car dans les conditions du dépôt MOCVD, le composé YBaCO présente une stoechiométrie de l'oxygène inférieure à 6,93 lui conférant une structure quadratique à haute température, qui transite vers une structure orthorhombique à 500°C. Néanmoins, pour s'approcher de la stoechiométrie idéale de 6,93, le refroidissement doit se faire en pression atmosphérique d'oxygène. Dans un procédé en ligne cette étape est effectuée séparément grâce à traitement post-dépôt à une température comprise entre 450°C et 600°C, de préférence entre 500°C et 600°, sous oxygène pur, pendant plusieurs heures, suivis d'une descente lente à quelques centaines de degrés par heure, typiquement 100°C/h. L'argent, compte tenu de sa perméabilité à l'oxygène et de son caractère inerte vis-à-vis de l'oxygène rend possible le traitement oxydant après l'étape de métallisation.

Nous décrivons ici deux variantes du procédé selon l'invention.

Dans une première variante, on approvisionne un substrat métallique plat, préalablement texturé biaxialement, qui est revêtu d'une couche tampon d'oxyde métallique épitaxique, en utilisant un procédé de l'état de la technique ou le procédé selon l'invention. Ce substrat plat est ensuite transformé en substrat long de section sensiblement circulaire ou elliptique, et typiquement un substrat tubulaire, de préférence par le procédé de soudage des chants décrit ci-dessus. Lors de ce procédé de roulage - soudage, la couche tampon est inévitablement endommagée, et il est nécessaire de redéposer une seconde couche tampon au-dessus de la première, par le procédé de dépôt décrit ci-dessus. On préfère déposer une ou plusieurs couches d'oxyde métallique épitaxique très mince, d'une épaisseur comprise entre 20 et 60 nm, et de manière encore plus préférée d'environ 40 nm. Ensuite, on poursuit le procédé selon l'invention comme décrit ci-dessus avec le dépôt de la couche de TRBaCuO ou YBaCuO (étape (iv)), le dépôt de la couche de protection en métal (étape (v)) et le traitement oxydant (étape (vi)).

Dans une deuxième variante, on approvisionne un substrat plat fortement écroui mais non texturé, et on le transforme en substrat métallique long de section sensiblement circulaire ou elliptique, et typiquement un substrat tubulaire, de préférence en utilisant le procédé de soudage des chants décrit ci-dessus. Ensuite, on effectue un recuit texturant, et poursuit le procédé selon l'invention comme décrit ci-dessus, avec un traitement de fonctionnalisation (étape (ii)), suivi du dépôt de la couche tampon (étape (iii)), le dépôt de la couche de TRBaCuO ou YBaCuO (étape (iv)), le dépôt de la couche de protection en métal (étape (v)) et le traitement oxydant (étape (vi)).

Le procédé selon l'invention a de nombreux avantages. Il permet la préparation de conducteurs supraconducteurs à haute température de section transversale sensiblement circulaire ou elliptique par un procédé continu (« reel-to-reel », i.e. effectué de bobine en bobine) de dépôt successif de couches de grande qualité cristallographique.

Dans un mode de réalisation particulier de l'invention, on utilise un substrat métallique texturé qui présente des rainures. On peut par exemple utiliser un substrat ondulé ou nervuré, qui a été préparé à partir d'une tôle plate par un procédé mécanique de déformation, par exemple par l'application de rouleaux. Ces rainures ou nervures sont disposées avantageusement dans une direction autre qu'orthogonale au sens long du substrat ; elles n'ont pas besoin d'être parallèles l'une par rapport à l'autre, ou parallèles à l'axe long du substrat. Sur de tels substrats, on peut déposer du TRBaCuO dans les espaces (creux) des rainures, nervures ou ondulations, ce qui génère des veines de matériau supraconducteur ; ainsi, on diminue les pertes en courant alternatif en fractionnant la section où circule le courant.

Le procédé selon l'invention est particulièrement bien adapté pour déposer une couche tampon homogène de type $A_{2-x}B_{2+x}O_7$ sur un tel substrat rainuré (tel qu'un substrat ondulé ou nervuré), alors que les procédé sous vide sur un tel substrat conduisent en général à des couches présentant une épaisseur inhomogène.

**Exemples**

Ces exemples servent à illustrer des modes de réalisation de l'invention, mais ne la limitent pas.

Exemple 1 :

On a élaboré des produits avantageux selon l'invention, qui présentent les caractéristiques suivantes :

- La couche tampon d'oxyde métallique est une couche de LZO, qui a typiquement une épaisseur comprise entre 80 nm et 210 nm.

- La couche de TRBaCuO ou YBaCuO est avantageusement une couche d'YBaCuO présentant une épaisseur comprise entre 200 nm et 500 nm, et typiquement de l'ordre de 350 nm.

- La couche de protection en métal est une couche d'argent, qui a typiquement une épaisseur comprise entre 250 nm et 450 nm, et typiquement de l'ordre de 350 nm.

Un tel fil d'YBaCuO déposé sur un fil texturé de Ni, présente une température $T_c$ d'au moins 83 K, préférentiellement d'au moins 85 K, et encore plus préférentiellement d'au moins 93 K. La densité de courant, mesurée à 4 K, est supérieure à 3 A par centimètre de périmètre.

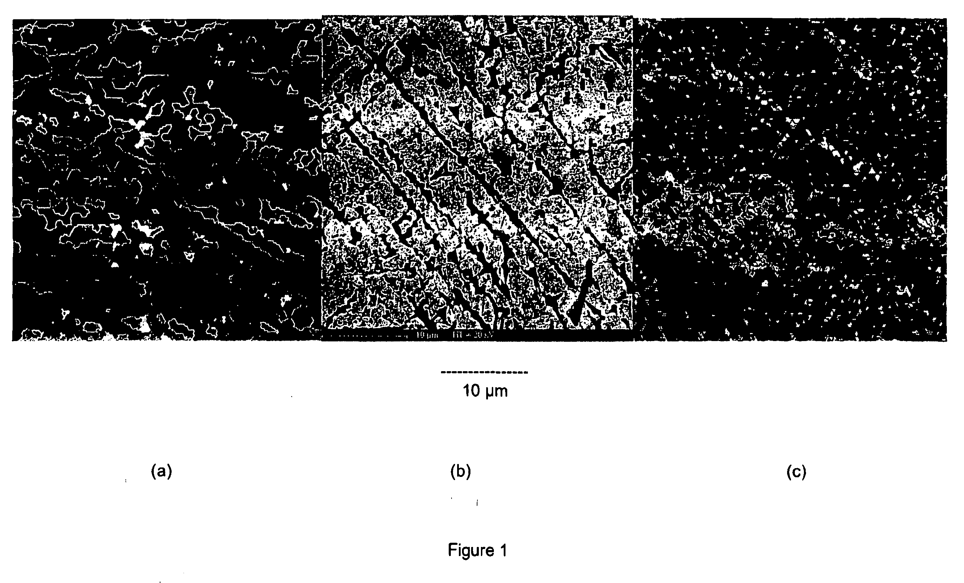

La figure 1 montre trois micrographies, obtenues par des techniques différentes, d'un même tube revêtu d'une couche de LZO déposée par le procédé selon l'invention. Dans cet exemple, on a déposé la couche de LZO d'une épaisseur de 110 nm sur un substrat plat Ni-5at%W texturé bi-axial, qui a été transformé en tube par un procédé de roulage - soudage.

La figure 1(b) montre une micrographie obtenue par microscopie électronique à balayage (tension d'accélération 20 kV) sur le tube roulé-soudé. Lors de la phase d'étirement, la couche de LZO est fracturée selon les bandes de Lüders générées par la déformation du substrat métallique. La micrographie montre les fractures de la couche LZO induites par cette déformation.

La figure 1(a) montre une micrographie obtenue par microscopie électronique à balayage en mode de diffraction d'électrons rétrodiffusés (EBSD = Electron BackScattered Surface Diffraction) du même tube. Cette technique donne des informations sur les orientations relatives des grains de la surface. Les parties sombres représentent des grains de $La_2Zr_2O_7$ avec leurs axes [001] parallèles à la normale de la surface du tube (axe r, voir la figure 4) et leurs axes [100] parallèles à l'axe du cylindre (Z). Les zones gris clair sont tournées de 45° par rapport aux précédentes (direction <110>). Il s'agit de zones de Ni-5at%W découvertes lors de la préparation du tube qui apparaissent en sombre sur la micrographie de la figure 1(b). Elles sont tournées de 45° par rapport aux grains de $La_2Zr_2O_7$ pour des raisons d'accord de maille cristallographique entre ces deux composés. Les régions blanches correspondent à des grains totalement désorientés.

La figure 1(c) montre une micrographie obtenue par microscopie électronique à balayage en mode de diffraction d'électrons rétrodiffusés dans des conditions identique à celles employées pour la figure 1(b), sur un tube dont la couche de LZO a été réparée par dépôt d'une deuxième couche de LZO par le procédé selon l'invention. On observe que ce deuxième dépôt bouche les zones vides causées par le processus de mise en forme du tube, qui sont visibles sur les figures 1(a) et 1(b).

Cet exemple montre que la surface fracturée de LZO, endommagé lors de la mise en forme d'un substrat métallique initialement plat, peut être réparée moyennant une deuxième couche de LZO déposée selon le procédé de l'invention.

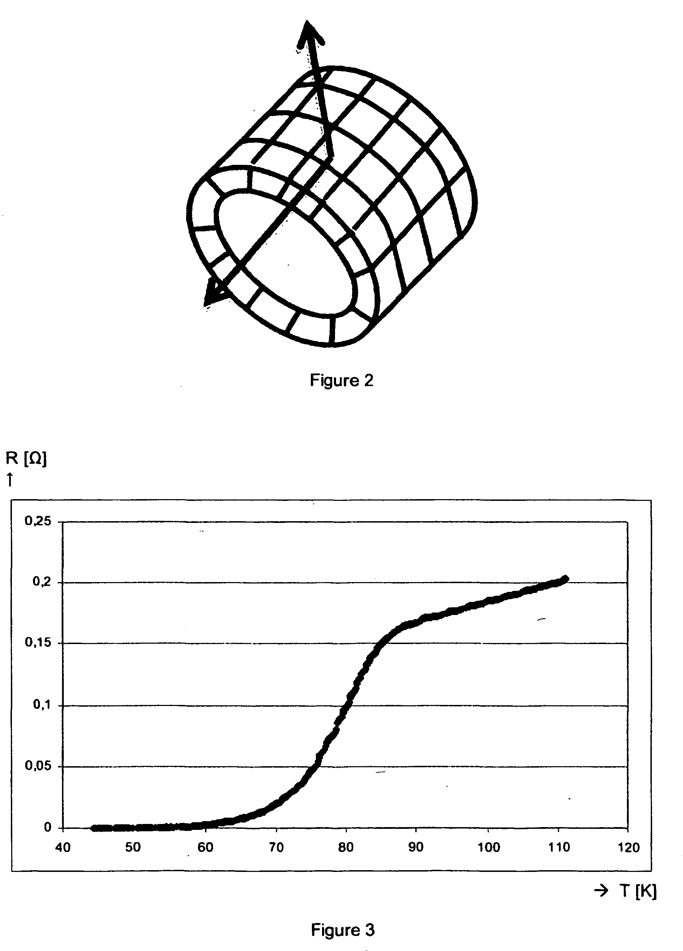

La figure 3 montre qu'un dépôt de YBaCuO sur un tel substrat peut présenter une résistivité de moins de 0,10 $\Omega$ à 80 K, et une résistivité nulle vers 60 K où il devient supraconducteur.

Exemple 2 :

Cet exemple décrit le dépôt d'une couche mince épitaxiée de $La_2Zr_2O_7$ sur tôle ondulée ou nervurée. Le substrat était une tôle nervurée de Ni texturée bi-axialement, d'épaisseur 80 $\mu$m, de longueur 4 cm, et de largeur 1 cm ; sa forme est montrée schématiquement sur la figure 5. Cette tôle a été obtenue à partir d'une tôle plate par pressage sur deux baguettes d'alumine de 1 mm de diamètre, disposées parallèlement à la longueur de l'échantillon et séparées de 7 mm environ. Après pressage la forme des baguettes s'incruste dans la tôle en donnant une forme ondulée possédant des saillies légèrement anguleuses. On note une augmentation significative de la raideur de la tôle facilitant sa manipulation.

Cette tôle a ensuite été trempée dans une solution d'un propionate d'un métal, de viscosité adéquate, puis extraite à la vitesse de 66 mm/min afin de la couvrir d'un dépôt uniforme. L'épaisseur de ce dépôt est déterminée par l'écoulement du liquide vers le bas, les paramètres critiques étant la viscosité et la tension de surface. Sur la surface de la tôle, les parties concaves font office de drains d'écoulement et l'épaisseur de la couche est plus faible dans ces parties, comme en témoigne la couleur finale du film après cristallisation. Inversement, les parties en saillies sont plus épaisses.

Après séchage à 60°C pendant quelques minutes, l'échantillon a été mis à cristalliser dans un four en suivant le traitement déjà décrit. Il en est ressorti un échantillon couvert d'un émail brillant dont la couleur reflète son épaisseur. Les parties planes sont bleues ciel, correspondant à une épaisseur de 80 -100 nm.

La structure cristalline a été observée par diffraction des rayons X avec un faisceau de 2 mm x 1 mm, de taille adaptée à sonder la partie plane. Celle-ci est bien cristallisée avec la texture attendue (direction [001]// à la normale de la surface et la direction [100] parallèle à la direction <110> du Ni), indiquant que l'ondulation n'a pas induit de perturbation sur cette zone.

La caractérisation structurale de la partie ondulée ne peut être faite de façon classique qu'en aplatissant celle-ci dans une presse. En revanche, la technique de microdiffraction permet d'éviter cette difficulté pouvant introduire des artéfacts lors de la mise à plat. L'observation de la tôle aplatie révèle une texture cube de bonne qualité (équivalent à celle de la partie plane) démontrant que l'ondulation crée n'avait pas d'influence à l'échelle de la mesure, soit sur une surface de quelques 2x1 mm². Ceci n'exclu pas que des distorsions puisse exister sur une échelle du micron sur les sommets des saillies, mais leur contribution à la moyenne est indiscernable.

Il est intéressant de noter que la mise à plat ne crée pas de fissurations longitudinales excessives de la couche, ce qui peut être expliqué par sa faible épaisseur. Cependant de courtes fissures perpendiculaires à la longueur de l'échantillon ont été observées et imputables à des contraintes dilatométriques.

**Revendications**

**1.** Procédé de dépôt d'une couche tampon d'oxyde métallique épitaxique sur une surface fonctionnalisée d'un substrat métallique texturé, ledit procédé comprenant les étapes suivantes:

(1) on dépose une couche d'un précurseur d'un oxyde de type $A_{2-x}B_{2+x}O_7$ où A représente un métal de valence 3 (tel que le La, Y, Gd, Dy, Lu, Sc, Nd, Sa ; le La étant préféré) ou un mélange de plusieurs de ces métaux, et B un métal de valence 4 (tel que le Zr, Ti, Sn, Hf, Pb, Ce ; te Zr étant préféré), tel que le $La_2Zr_2O_7$,(appelé aussi LZO), et x est un nombre compris entre -0,1 et +0,1 , à partir d'une solution des carboxylates (et préférentiellement des propionales) desdits métaux A et B, cette solution ayant une viscosité, mesurée à la température du procédé, comprise entre 1 mPa s et 20 mPa s, et préférentiellement comprise entre 2 mPa s et 10 mPa s,

(2) on laisse sécher ladite couche de précurseur d'oxyde, de préférence à une température comprise entre 60°C et 150°C, et de préférence entre 80 et 100°C,

(3) on effectue un traitement thermique pour pyrolyser ledit précurseur d'oxyde et pour former l'oxyde, au moins une partie dudit traitement thermique étant effectuée sous balayage de gaz réducteur, de préférence Ar + 5%(vol) $H_2$), ledit gaz réducteur ayant de préférence une vitesse de balayage supérieure à 0,005 cm/s, préférentiellement comprise entre 0,012 cm/s et 0,1 cm/s, et encore plus préférentiellement comprise entre 0,04 cm/s et 0.08 cm/s.

**2.** Procédé selon la revendication 1, **caractérisé en ce que** le traitement thermique (étape (3)) comprend une phase dite de pyrolyse et une phase dite de cristallisation, la phase de pyrolyse impliquant un traitement thermique compris entre 150°C et environ 450°C (et de préférence ne pas dépassant 350°C), et la phase de cristallisation impliquant un traitement thermique compris entre environ 450°C et environ 1100°C.

3. Procédé selon la revendication 1 ou 2, **caractérisé en ce que** ledit traitement thermique (étape (3)) comprend un traitement à une température T comprise entre 800°C et 1100°C, et préférentiellement entre 850°C et 1000°C, pour former l'oxyde.

4. Procédé selon l'une quelconque des revendications 1 à 3, **caractérisé en ce que** le traitement thermique comprend une vitesse de montée en température comprise entre 100°C/h et 2000°C/h, préférentiellement entre 250°C/h et 2000°C/h et encore plus préférentiellement entre 500°C/h et 2000°C/h, suivi d'un palier à la température T pendant une durée comprise entre 1 et 120 minutes, préférentiellement entre 10 et 90 minutes, et encore plus préférentiellement entre 20 et 60 minutes, et suivi d'un refroidissement à une vitesse comprise entre 100°C/h et 2000°C/h, préférentiellement entre 100°C/h et 1000°C/h et encore plus préférentiellement entre 100°C/h et 500°C/h.

5. Procédé selon l'une quelconque des revendications 2 à 4, **caractérisé en ce que** la phase de pyrolyse est effectué au moins en partie à une pression réduite.

6. Procédé selon l'une quelconque des revendications 2 à 5, **caractérisé en ce que** la phase de cristallisation est effectuée sous balayage de gaz réducteur.

7. Procédé selon l'une quelconque des revendications 1 à 6, **caractérisé en ce que** ledit substrat métallique est un substrat métallique long de section sensiblement circulaire ou elliptique, à texture cube présentant des grains dont la direction [001] est perpendiculaire au sens long du substrat, et dont la direction [100] est parallèle au sens long du substrat.

8. Procédé selon l'une quelconque des revendications 1 à 7, **caractérisé en ce que** ledit substrat métallique présente des rainures, telles que des ondulations ou des nervures.

9. Utilisation du procédé selon l'une quelconque des revendications 1 à 8 dans un procédé de fabrication de dispositifs supraconducteurs comportant une couche supracondutrice d'oxyde mixte Terre Rare - Baryum - Cuivre (TRBaCuO) et notamment d'oxyde mixte Yttrium - Baryum - Cuivre (YBaCuO ou YBCO), ladite couche supraconductrice étant déposé sur ladite couche tampon.

10. Procédé de fabrication d'un conducteur électrique supraconducteur de section transversale sensiblement circulaire ou elliptique, ledit conducteur comportant une couche d'oxyde mixte d'Yttrium - Baryum - Cuivre (YbaCuO ou YBCO) en tant que matériau supraconducteur déposée sur un substrat métallique de section sensiblement circulaire, ledit procédé comportant, dans l'ordre indiqué, les étapes suivantes :

(a) on approvisionne un substrat métallique long de section sensiblement circulaire ou elliptique, et typiquement un substrat tubulaire, ledit substrat ayant une texture cube présentant des grains dont la direction [001] est perpendiculaire au sens long du substrat, et dont la direction [100] est parallèle au sens long du substrat ;
(b) on effectue un traitement de fonctionnalisation au moins de la surface externe dudit substrat métallique, de préférence par un traitement au $H_2S$;
(c) on dépose une couche tampon d'oxyde de métaux épitaxique au moins sur la surface externe fonctionnalisée dudit tube à partir d'une solution liquide, en utilisant le procédé selon l'une quelconque des revendications 1 à 8 ;
(d) on dépose la couche de TRBaCuO. et notamment de YbaCuO, sur la couche d'oxyde métallique déposée à l'étape (c) ;
(e) on dépose une couche de protection en métal, de préférence en argent ;
(f) on effectue un traitement oxydant.

11. Procédé selon la revendication 10, **caractérisé en ce que** le traitement au $H_2S$ est effectuée à une pression comprise entre $10^{-3}$ et 10 bar, et de préférence à la pression atmosphérique.

12. Procédé selon la revendication 11, **caractérisé en ce que** le traitement au $H_2S$ est effectué pendant une durée d'au moins une minute.

13. Conducteur électrique supraconducteur de section transversale sensiblement circulaire ou elliptique susceptible d'être obtenu par le procédé selon l'une quelconque des revendications 10 à 12.

14. Conducteur électrique supraconducteur selon la revendication 13, **caractérisé en ce qu'**il présente une température $T_c$ d'au moins 83 K, préférentiellement d'au moins 85 K et encore plus préférentiellement d'au moins 93 K.

15. Conducteur électrique supraconducteur selon la revendication 13 ou 14, **caractérisé en ce qu'**il présente une densité de courant, mesurée à une température de 4 K, supérieure à 3 A par centimètre de périmètre.

**Patentansprüche**

1. Verfahren zur Abscheidung einer epitaktischen Metalloxid-Pufferschicht auf einer funktionalisierten Fläche eines texturierten Metallsubstrats, wobei das Verfahren die folgenden Schritte umfasst:

    (1) Abscheiden einer Schicht aus einem Vorläufer eines Oxids des Typs $A_{2-x}B_{2+x}O_7$, wobei A für ein Metall mit einer Wertigkeit von 3 (wie La, Y, Gd, Dy, Lu, Sc, Nd, Sa; wobei La bevorzugt ist) oder ein Gemisch mehrerer dieser Metalle steht und B ein Metall mit einer Wertigkeit von 4 (wie Zr, Ti, Sn, Hf, Pb, Ce; wobei Zr bevorzugt ist) ist, wie $La_2Zr_2O_7$ (das auch als LZO bezeichnet wird), und x eine Zahl zwischen -0,1 und +0,1 ist, aus einer Lösung von Carboxylaten (und vorzugsweise Propionaten) der besagten Metalle A und B, wobei diese Lösung eine Viskosität - gemessen bei der Temperatur des Verfahrens - zwischen 1 mPa s und 20 mPa s und vorzugsweise zwischen 2 mPas und 10 mPa s hat,
    (2) Trocknenlassen der besagten Oxidvorläuferschicht, vorzugsweise bei einer Temperatur zwischen 60°C und 150°C und vorzugsweise zwischen 80 und 100°C,
    (3) Durchführen einer Wärmebehandlung, um den besagten Oxidvorläufer zu pyrolysieren und um das Oxid zu bilden, wobei mindestens ein Teil der besagten Wärmebehandlung unter Spülung mit einem reduzierenden Gas, vorzugsweise Ar + 5 Vol.-% $H_2$ durchgeführt wird, wobei das besagte reduzierende Gas vorzugsweise eine Spülrate von mehr als 0,005 cm/s, vorzugsweise zwischen 0,012 cm/s und 0,1 cm/s und noch mehr bevorzugt zwischen 0,04 cm/s und 0,08 cm/s hat.

2. Verfahren nach Anspruch 1, **dadurch gekennzeichnet, dass** die Wärmebehandlung (Schritt (3)) eine so genannte Pyrolysephase und eine so genannte Kristallisationsphase umfasst, wobei die Pyrolysephase eine Wärmebehandlung zwischen 150°C und ungefähr 450°C (und vorzugsweise nicht 350°C übersteigend) beinhaltet und die Kristallisationsphase eine Wärmebehandlung zwischen ungefähr 450°C und ungefähr 1100°C beinhaltet.

3. Verfahren nach Anspruch 1 oder 2, **dadurch gekennzeichnet, dass** die besagte Wärmebehandlung (Schritt (3)) eine Behandlung bei einer Temperatur T zwischen 800°C und 1100°C und vorzugsweise zwischen 850°C und 1000°C umfasst, um das Oxid zu bilden.

4. Verfahren nach einem der Ansprüche 1 bis 3, **dadurch gekennzeichnet, dass** die Wärmebehandlung eine Temperaturanstiegsrate zwischen 100°C/h und 2000°C/h, vorzugsweise zwischen 250°C/h und 2000°C/h und noch mehr bevorzugt zwischen 500°C/h und 2000°C/h, gefolgt von einer Zwischenphase bei der Temperatur T für einen Zeitraum zwischen 1 und 120 Minuten, vorzugsweise zwischen 10 und 90 Minuten und noch mehr bevorzugt zwischen 20 und 60 Minuten und gefolgt von einer Kühlung mit einer Rate zwischen 100°C/h und 2000°C/h, vorzugsweise zwischen 100°C/h und 1000°C/h und noch mehr bevorzugt zwischen 100°C/h und 500°C/h umfasst.

5. Verfahren nach einem der Ansprüche 2 bis 4, **dadurch gekennzeichnet, dass** die Pyrolysephase mindestens zum Teil bei einem verringerten Druck durchgeführt wird.

6. Verfahren nach einem der Ansprüche 2 bis 5, **dadurch gekennzeichnet, dass** die Kristallisationsphase unter Spülung mit einem reduzierenden Gas durchgeführt wird.

7. Verfahren nach einem der Ansprüche 1 bis 6, **dadurch gekennzeichnet, dass** das besagte Metallsubstrat ein langes Metallsubstrat mit einem im Wesentlichen kreisförmigen oder elliptischen Querschnitt und mit einer kubischen Textur ist, die Körner aufweist, deren Richtung [001] senkrecht zu der Längsrichtung des Substrats ist und deren Richtung [100] parallel zu der Längsrichtung des Substrats ist.

8. Verfahren nach einem der Ansprüche 1 bis 7, **dadurch gekennzeichnet, dass** das besagte Metallsubstrat Nuten aufweist, wie Wellen oder Rippen.

9. Verwendung des Verfahrens nach einem der Ansprüche 1 bis 8 in einem Verfahren zur Herstellung von Supraleitervorrichtungen, die eine supraleitende Schicht aus einem gemischten Seltenerdmetall-/Barium-/Kupferoxid (SEMBaCuO) und insbesondere einem gemischten Yttrium-/Barium-/Kupferoxid (YBaCuO oder YBCO) enthält, wobei die besagte supraleitende Schicht auf der besagten Pufferschicht abgeschieden wird.

10. Verfahren zur Herstellung eines supraleitenden elektrischen Leiters mit einem im Wesentlichen kreisförmigen oder elliptischen Querschnitt, wobei der besagte Leiter eine Schicht aus einem gemischten Yttrium-/Barium-/Kupferoxid (YBaCuO oder YBCO) als ein Supraleitermaterial enthält, die auf einem Metallsubstrat mit einem im Wesentlichen kreisförmigen Querschnitt abgeschieden wird, wobei das Verfahren die folgenden Schritte in der angegebenen Reihenfolge umfasst:

    (a) Bereitstellen eines langen Metallsubstrats mit einem im Wesentlichen kreisförmigen oder elliptischen Querschnitt und in der Regel eines rohrförmigen Substrats, wobei das besagte Substrat eine kubische Textur hat, die Körner aufweist, deren Richtung [001] senkrecht zu der Längsrichtung des Substrats ist und deren Richtung [100] parallel zu der Längsrichtung des Substrats ist;

(b) Durchführen einer Funktionalisierungsbehandlung an mindestens der Außenfläche des besagten Metallsubstrats, vorzugsweise durch eine Behandlung mit $H_2S$;

(c) Abscheiden einer epitaktischen Metalloxid-Pufferschicht auf mindestens der funktionalisierten Außenfläche des besagten Rohrs aus einer flüssigen Lösung unter Verwendung des Verfahrens nach einem der Ansprüche 1 bis 8;

(d) Abscheiden der SEMBaCuO- und insbesondere YBaCuO-Schicht auf der im Schritt (c) abgeschiedenen Metalloxidschicht;

(e) Abscheiden einer Schutzschicht aus Metall, vorzugsweise aus Silber;

(f) Durchführen einer oxidierenden Behandlung.

**11.** Verfahren nach Anspruch 10, **dadurch gekennzeichnet, dass** die Behandlung mit $H_2S$ bei einem Druck zwischen $10^{-3}$ und 10 bar und vorzugsweise bei atmosphärischem Druck durchgeführt wird.

**12.** Verfahren nach Anspruch 11, **dadurch gekennzeichnet, dass** die Behandlung mit $H_2S$ für einen Zeitraum von mindestens einer Minute durchgeführt wird.

**13.** Supraleitender elektrischer Leiter mit einem im Wesentlichen kreisförmigen oder elliptischen Querschnitt, der durch das Verfahren nach einem der Ansprüche 10 bis 12 erhalten werden kann.

**14.** Supraleitender elektrischer Leiter nach Anspruch 13, **dadurch gekennzeichnet, dass** er eine Temperatur $T_c$ von mindestens 83 K, vorzugsweise mindestens 85 K und noch mehr bevorzugt mindestens 93 K aufweist.

**15.** Supraleitender elektrischer Leiter nach Anspruch 13 oder 14, **dadurch gekennzeichnet, dass** er eine Stromdichte - gemessen bei einer Temperatur von 4 K - von mehr als 3 A pro Umfangszentimeter aufweist.

Le document « *La$_2$Zr$_2$O$_7$ films on Cu-Ni alloy by chemical solutions deposition process* » par Z.M. Yu et al, publié dans la revue Material Science and Engineering B130 (2006-06-15), pages 126-131, décrit des films de La$_2$Zr$_2$O$_7$ (LZO) formés par une technique de dépôt par voie humide (appelée « Chemical Solution Deposition, CSD) sur des rubans de Cu-Ni texturés bi-axialement obtenus à partir de constantan (Cu55Ni45) laminé (substrats de type RaBiTS). Les précurseurs à base d'acétylacétonates étaient traités avec l'acide propionique (0,1 - 0,87 mol/l) et déposés par spin-coating. Le film de LZO commençait à cristalliser à partir de 850°C, et une nucléation du film avec une texture bi-axiale a été observé sur le substrat (l'axe de la cellule élémentaire étant décalé de 45° par rapport ä celle du substrat). Cependant, la partie supérieure du film ne montrait pas de texture même après un recuit de longue durée 1100°C, seule la partie interfaciale montrait la texture bi-axiale.

**Claims**

**1.** Method for depositing an epitaxial metal oxide buffer layer on a functionalised surface of a textured metal substrate, said method comprising the following steps:

(1) depositing a layer of a precursor of an oxide of the type $A_{Z-x}B_{2+x}O7$ where A represents a metal of valence 3 (such as La, Y, Gd, Dy, Lu, Sc, Nd, Sa; La being preferred) or a mixture of a plurality of these metals, and B a metal of valence 4 (such as Zr, Ti, Sn, Hf, Pb, Ce; Zr being preferred), such as $La_2Zr_2O_7$ (also called LZO), and x is a number between -0.1 and +0.1, using a solution of the carboxylates (and preferentially the propionates) of said metals A and B, this solution having a viscosity, measured at the temperature of the method, between 1 mPa s and 20 mPa s, and preferentially between 2 mPa s and 10 mPa s,

(2) allowing said layer of oxide precursor to dry, preferably at a temperature between 60°C and 150°C, and preferably between 80 and 100°C,

(3) performing a heat treatment to pyrolyse said oxide precursor and to form the oxide, at least a portion of said heat treatment being performed under a reducing gas sweep, preferably Ar + 5%(vol) $H_2$), said reducing gas preferably having a sweep rate greater than 0.005 cm/s, preferentially between 0.012 cm/s and 0.1 cm/s, and more preferentially between 0.04 cm/s and 0.08 cm/s.

**2.** Method according to claim 1, **characterised in that** the heat treatment (step (3)) comprises a so-called pyrolysis phase and a so-called crystallisation phase, the pyrolysis phase involving a heat treatment between 150°C and approximately 450°C (and preferably not exceeding 350°C), and the crystallisation phase involving a heat treatment between approximately 450°C and approximately 1100°C.

**3.** Method according to claim 1 or 2, **characterised in**

**that** said heat treatment (step (3)) comprises a treatment at a temperature T between 800°C and 1100°C, and preferentially between 850°C and 1000°C, to form the oxide.

4. Method according to any of claims 1 to 3, **characterised in that** the heat treatment comprises a temperature rise rate between 100°C/hr and 2000°C/hr, preferentially between 250°C/hr and 2000°C/hr and more preferentially between 500°C/hr and 2000°C/hr, followed by a plateau at the temperature T for a time between 1 and 120 minutes, preferentially between 10 and 90 minutes, and more preferentially between 20 and 60 minutes, and followed by cooling at a rate between 100°C/hr and 2000°C/hr, preferentially between 100°C/hr and 1000°C/hr and more preferentially between 100°C/hr and 500°C/hr.

5. Method according to any of claims 2 to 4, **characterised in that** the pyrolysis phase is performed at least in part at a reduced pressure.

6. Method according to any of claims 2 to 5, **characterised in that** the crystallisation phase is performed under a reducing gas sweep.

7. Method according to any of claims 1 to 6, **characterised in that** said metal substrate is a long metal substrate having a substantially circular or elliptical cross-section, with a cube texture having grains wherein the direction [001] is perpendicular to the longitudinal direction of the substrate, and wherein the direction [100] is parallel to the longitudinal direction of the substrate.

8. Method according to any of claims 1 to 7, **characterised in that** said metal substrate has grooves, such as corrugations or ribs.

9. Use of the method according to any of claims 1 to 8 in a method for manufacturing superconducting devices comprising a superconductor layer of mixed Rare Earth-Barium - Copper oxide (TRBaCuO) and notably mixed Yttrium - Barium - Copper oxide (YBaCuO or YBCO), said superconductor layer being deposited on said buffer layer.

10. Method for manufacturing a superconducting electric conductor having a substantially circular or elliptical cross-section, said conductor comprising a mixed Yttrium

- Barium - Copper oxide (YBaCuO or YBCO) as the superconducting material deposited on a metal substrate having a substantially circular cross-section, said method comprising, in the order given, the following steps:

(a) providing a long metal substrate having a substantially circular or elliptical cross-section, and typically a tubular substrate, said substrate having a cube texture having grains wherein the direction [001] is perpendicular to the longitudinal direction of the substrate, and wherein the direction [100] is parallel to the longitudinal direction of the substrate;
(b) performing a functionalisation treatment at least of the outer surface of said metal substrate, preferably by means of a treatment with $H_2S$;
(c) depositing an epitaxial metal oxide buffer layer a least one the functionalised outer surface of said tube using a liquid solution, using the method according to any of claims 1 to 8;
(d) depositing the layer of TRBaCuO, and particularly of YBaCuO, on the layer of metal oxide deposited in step (c);
(e) depositing a protective layer of metal, preferably silver;
(f) performing an oxidising treatment.

11. Method according to claim 10, **characterised in that** the treatment with $H_2S$ is performed at a temperature between $10^{-3}$ and 10 bar, and preferably at atmospheric pressure.

12. Method according to claim 11, **characterised in that** the treatment with $H_2S$ is performed for a time of at least one minute.

13. Superconducting electric conductor having a substantially circular or elliptical cross-section suitable for being obtained using the method according to any of claims 10 to 12.

14. Superconducting electric conductor according to claim 13, **characterised in that** it has a temperature $T_c$ of at least 83 K, preferentially at least 85 K and more preferentially at least 93 K.

15. Superconducting electric conductor according to claim 13 or 14, **characterised in that** it has a current density, measured at a temperature of 4 K, greater than 3 A per centimetre of perimeter.

10 μm

(a)      (b)      (c)

Figure 1

Figure 2

Figure 3

Figure 4

Figure 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9502711 A
- US 5945162 A
- US 6451450 B
- WO 2008078852 A
- US 6537689 B
- US 7261776 B
- US 20080113869 A
- US 20080039330 A, Wolf

- US 200701977045 A
- US 20070026247 A
- EP 1916720 A, Nexans
- US 20080119365 A, d'Arnaud Allais et Nat Dirk
- US 20070197395 A
- US 20070179063 A
- WO 9308838 A

**Littérature non-brevet citée dans la description**

- **S.R. FOLTYN et al.** Overcoming the barrier to 1000 A/cm width superconducting coatings. *Applied Physics Letters,* 2005, vol. 87 (16), 162505
- **QING HE, D.K. CHRISTEN et al.** Deposition of biaxially-oriented metal and oxide buffer-layer films on textured Ni tapes : new substrate for high-current, high-temperature superconductors. *Physica C,* 1997, vol. 275, 155-161
- **A. GOYAL et al.** Using RABiTS to Fabricate High-Temperature Superconducting Wire. *JOM,* Juillet 1999, 19-23
- **J.L. SOUBEYROUX et al.** Industrial Fe-Ni alloys for HTS coated conductor tapes. *Journal of Physics, Conference Series,* 2008, vol. 97, 012069
- **A. GOYAL et al.** Recent progress in the fabrication of high-JC tapes by epitaxial deposition of YBCO on RABiTS. *Physica C,* 2001, vol. 357-360, 903-913
- **A. VILLAUME et al.** In situ strain and transport magneto-optical investigations in superconductors. *Superconductor Science and Technology,* 2008, vol. 21, 034009

- **CAROFF et al.** La2Zr2O7 single buffer layer for YBaCuO RABiTS coated conductors. *Supercond. Sci. Technol.,* 2008, vol. 21, 075007
- **K. KNOTH et al.** Growth of thick chemical solution derived pyrochlore La2Zr2O7 buffer layers for YBa2Cu3O7-x coated conductors. *Thin Solid Films,* 2008, vol. 516, 2099-2108
- **H.C. FREYHARDT et al.** YBaCuO Thick Films on Planar and Curved Technical Substrates. *IEEE Transactions on Applied Superconductivity,* 1997, vol. 7 (2), 1426-1431
- **Z. M. YU.** La2Zr2O7 films on Cu-Ni alloy by chemical solution deposition process. *MATERIALS SCIENCE AND ENGINEERING B,* 15 Juin 2006, vol. 130, 126-131
- **C. CANTONI et al.** *RHEED Studies of Epitaxial Oxide Seed-Layer Growth on RABiTS Ni(001) : The Role of Surface Structure and Chemistry*
- **CAROFF et al.** *Sup.Sci.Technol.,* 2008, vol. 21, 075007
- **KNOTH et al.** *Sup. Sci.Technol.,* 2005, vol. 18, 334-339
- **DONET et al.** *J. Phys IV Pr 11 AA 319,* 2001